# EUROPÄISCHE PATENTANMELDUNG

(11) **EP 4 008 813 A1**
(43) Veröffentlichungstag der Anmeldung: **08.06.2022**
(21) Anmeldenummer: 20211881.6
(22) Anmeldetag: 04.12.2020
(51) Int. Cl.: C30B 29/06, C30B 15/22

(54) **VERFAHREN ZUM ZIEHEN EINES EINKRISTALLS NACH DER CZOCHRALSKI-METHODE**

(71) Anmelder: Siltronic AG, 81677 München (DE)
(72) Erfinder: Daniel, Matthias, 09599 Freiberg (DE); Stockmeier, Ludwig, 01187 Dresden (DE)

(57) **Zusammenfassung**

Verfahren zum Ziehen eines Einkristalls aus Silizium aus einer Schmelze, die in einem Tiegel enthalten ist, umfassend das Ziehen eines Einkristalls in einer ersten Phase, in der ein Anfangskonus entsteht, wobei ein Durchmesser D(to) und ein Kristallwinkel ω(t₀) jeweils zum Zeitpunkt t₀ bestimmt wird und eine Regelung verwendet wird, deren Führungsgröße den Durchmesser D(to) enthält, und das Ziehen des Einkristalls in einer zweiten Phase, in der ein zylindrischer Abschnitt mit einem Zieldurchmesser D_{T} (Stabphase) entsteht, wobei eine Regelung verwendet wird, deren Führungsgröße die Länge des zylindrischen Abschnitts enthält, und der Wechsel zwischen der ersten Phase und der zweiten Phase dann vollzogen wird, sobald alternativ folgende Kriterien erfüllt sind:
Winkelkriterium: D(to) > D_{T} - Δ_{dω} und co(to) < ω_{max,}
Durchmesserkriterium: D(to) > D_{T} - Δ_{dd,}
wobei die Abweichung vom Zieldurchmesser für das Winkelkriterium Δ_{dω} nicht kleiner ist als 0 mm und nicht größer ist als 6 mm und der maximale Kristallwinkel ωₘₐₓ nicht kleiner ist als 0° und nicht größer ist als 20° und die Abweichung vom Zieldurchmesser für das Durchmesserkriterium Δ_{dd} nicht kleiner ist als -2 mm und nicht größer ist als 5 mm.

## Beschreibung

Gegenstand der Erfindung ist ein Verfahren zum Ziehen eines Einkristalls aus Halbleitermaterial aus einer Schmelze, die in einem Tiegel enthalten ist, umfassend das Ziehen des Einkristalls in einer Phase, in der ein Anfangskonus des Einkristalls entsteht, bis zu einer Phase, in der mit dem Ziehen eines zylindrischen Abschnitts des Einkristalls begonnen wird.

### Stand der Technik

Die Herstellung eines Einkristalls aus Halbleitermaterial nach der Czochralski-Methode hat üblicherweise zum Ziel, einen Einkristall zu erhalten, von dem eine möglichst große Anzahl an Halbleiterscheiben erhalten werden kann. Die Form des Einkristalls umfasst einen vergleichsweise kurzen konusförmigen Abschnitt oder Anfangskonus und einen vergleichsweisen langen zylindrischen Abschnitt. Die Halbleiterscheiben werden vom zylindrischen Abschnitt erhalten. Dementsprechend umfasst das Ziehen des Einkristalls eine Phase, in der der Anfangskonus entsteht und eine Phase, in der der zylindrische Abschnitt entsteht. Das Ziehen eines Übergangs vom Anfangskonus zum zylindrischen Abschnitt wird Umbiegen (shouldering) genannt.

Die alleinige Regelung (closed loop control) des Durchmessers des Einkristalls auf einen Zieldurchmesser ist während der Phase des Umbiegens nach Stand der Technik nicht empfehlenswert, weil die dafür notwendige Messung des Durchmessers des Einkristalls Störungen unterliegt. Der Durchmesser des wachsenden Einkristalls lässt sich nur anfänglich direkt messen, solange kein heller Ring am Meniskus sichtbar ist. Als Meniskus wird der sich von der Oberfläche der Schmelze bis zum unteren Rand des wachsenden Einkristalls erhebende Teil der Schmelze bezeichnet, der sich auf Grund von Oberflächenspannungs- und Grenzflächenspannungs-Effekten bildet. Im Meniskus spiegeln sich glühend heiße Bestandteile der näheren Umgebung des Einkristalls, wie beispielsweise die Tiegelwand. Die Spiegelung der Tiegelwand wird auf einer Kamera-Aufnahme vom Bereich der Phasengrenze zwischen wachsendem Einkristall und Schmelze als heller Ring wahrgenommen. Das Erscheinen des hellen Rings verlegt den Hell/Dunkel-Übergang nach außen und macht so die direkte Messung des Durchmessers des Einkristalls und eine darauf beruhende Regelung des Durchmessers unmöglich.

In der WO 01/29292 A1 ist ein Verfahren beschrieben, umfassend das Vorhersagen eines Durchmessers, bei dessen Erreichen mit dem Umbiegen begonnen wird, und zwar in der Weise, dass beim Erreichen des vorhergesagten Durchmessers die Ziehgeschwindigkeit von einer ersten auf eine zweite Sollziehgeschwindigkeit erhöht wird.

Dieses Verfahren ist nicht besonders flexibel, weil nicht bei einem beliebigen Durchmesser, sondern nur beim vorhergesagten Durchmesser mit dem Umbiegen begonnen werden kann.

In der WO 2018 069 051 A1wird ein Verfahren zum Ziehen eines Einkristalls aus Halbleitermaterial aus einer Schmelze beschrieben, bei dem die Änderung des Durchmessers in der Konusphase bestimmt wird und daraus die Ziehgeschwindigkeit während der Konusphase mittels eines iterativen Rechenprozesses vorausbestimmt wird. Zusätzlich wird ein Verfahren zum Zuführen von Wärme zur Phasengrenze zwischen dem Rand des Einkristalls und der Schmelze durch Steuerung der zeitabhängigen Heizleistung einer ringförmigen Heizvorrichtung, die über der Schmelze angeordnet ist, beschrieben. Dabei wird der zeitliche Verlauf der Heizleistung der ringförmigen Heizvorrichtung während der Konusphase mittels eines iterativen Rechenprozesses vorausbestimmt.

In der EP 1 169 497 A1 wird ein Verfahren zur Steuerung des Wachstums eines sich verjüngenden Teils eines Halbleiter-Einkristalls auf der Grundlage der Veränderung des Durchmessers während der Verjüngung beschrieben. Dabei berechnet eine Steuereinheit eine Messung des Konuswinkels als Funktion einer Änderung des Kristalldurchmessers relativ zu einer Änderung der Kristalllänge. Der Regler erzeugt dann ein Fehlersignal als Funktion der Differenz zwischen der Messung der Kegelsteigung und einer Ziel-Kegelsteigung und liefert eine Zielziehgeschwindigkeitskorrektur an die Kristallantriebseinheit als Funktion des Fehlersignals.

### Problembeschreibung

Eine Konusphase wird als die Phase des Kristallziehens verstanden, bei dem der Durchmesser willentlich verändert wird. Dabei wird zwischen Anfangskonus und Endkonus unterschieden. Als Anfangskonus wird dabei als die Phase verstanden, bei dem der Kristall mit zunehmender Zeit im Durchmesser wächst, während ein Endkonus als die Phase des Kristallziehens verstanden wird, bei dem der Durchmesser des Kristalls mit zunehmender Zeit abnimmt. Die Stabphase wird demnach verstanden als die Phase des Kristallziehens, bei dem der Durchmesser im Wesentlichen zeitlich konstant bleibt.

In den genannten Dokumenten des Standes der Technik werden unterschiedliche Regelmechanismen zwischen den einzelnen Phasen des Kristallziehens vorgeschlagen, die neben anderen positiven Effekten zum Beispiel auch notwendig sind, um die Ausbeute des Kristallziehens zu erhöhen.

Der Durchmesser eines Kristalls ist in jeder Phase des Kristallziehens größeren und kleineren Fluktuationen unterworfen, die zwar nicht gewollt sind, aber aus physikalischen Gründen hingenommen werden müssen. Besagte Fluktuationen im Durchmesser des Kristalls machen es schwierig, während des Kristallziehens den genauen Zeitpunkt zu bestimmen, ab wann sich der Kristall in einer neuen Phase befinden soll.

Auch können zum Beispiel unvermeidbare kleine zeitliche Veränderungen der Eigenschaften (z.B. thermische Leitfähigkeit, Emissivität, etc.) der verwendeten Einbauteile in der Kristallziehanlage die Wärmebilanz und damit das Verhalten des Kristallziehens zwischen den einzelnen Kristallziehprozessen beeinflussen und so ungewollte Fluktuationen zwischen einzelnen Kristallen hervorrufen.

Und nicht zuletzt kann der Wechsel von Einbauteilen (z.B. Tiegel, Isolierungen, etc.) verursachen, dass ein Kristall, der nach dem Eingriff gezogen wurde, sich unterschiedlich verhält, zu einem Kristall, der vor dem Eingriff gezogen wurde.

Es kann beispielsweise vorkommen, dass der Zieldurchmesser eines Kristalls, der sich in der Konusphase (mit den damit verbundenen Regelparametern) befindet, nicht erreicht wird und kein oder nur ein unzureichender Durchmesserzuwachs stattfindet. Ein manueller Eingriff ist dann nötig, um entweder Regelparameter von Hand zu verändern oder den schon erhaltenen Stab zurückzuschmelzen. Beide Fälle haben wirtschaftliche Konsequenzen, im ersten Fall eine nicht optimale Stabform, die sich in einer schlechten Ausbeute, die sich bei der Herstellung von Halbleiterscheiben bemerkbar macht und in anderen Fall einen erheblichen zeitlichen Ausbeuteverlust, da das Rückschmelzen Zeit und Energie kostet.

Das Umbiegen stellt einen sehr sensitiven Moment des Kristallziehens dar, was darin münden kann, dass es gerade am Anfang der Stabphase zu größeren Schwankungen des Durchmessers kommen kann. Diese müssen in der Stabphase so ausgeregelt werden, dass der Stab möglichst schnell einen im wesentlichen konstanten Durchmesser aufweist und gleichzeitig dürfen die thermischen Bedingungen im schon gezogenen Stab nicht erheblich verändert werden. Beides zusammen ist nur schwer möglich, so dass dies mit einer hohen Wahrscheinlichkeit zu Ausbeuteverlusten führt.

Die Erfinder haben erkannt, dass gerade das genaue Erkennen und Festlegen des Zeitpunktes des Wechsels der Phase, beispielsweise des Wechsels vom Anfangskonus zur Stabphase, einen erheblichen Einfluss auf die Ausbeute des Kristallziehens hat, und zwar dann, wenn zusammen mit dem Phasenwechsel auch ein Wechsel eines Satzes der Regelungsparameter des Kristallziehens einhergeht. Eine Lösung für dieses Problem ist im Stand der Technik nicht dargelegt.

Die Aufgabe ist es daher, ein Verfahren bereitzustellen, das während des Kristalls den Zeitpunkt des Phasenwechsels zwischen Anfangskonus und Stabphase möglichst genau bestimmt und damit den Zeitpunkt festlegt, wann der Satz an Regelparameter gewechselt wird.

Die Aufgabe der Erfindung wird gelöst durch ein Verfahren zum Ziehen eines Einkristalls aus Silizium aus einer Schmelze, die in einem Tiegel enthalten ist, umfassend das Ziehen eines Einkristalls in einer ersten Phase, in der ein Anfangskonus entsteht, wobei ein Durchmesser D(t₀) und ein Kristallwinkel ω(t₀) jeweils zum Zeitpunkt t₀ bestimmt wird und eine Regelung verwendet wird, deren Führungsgröße den Durchmesser D(t₀) enthält, und das Ziehen des Einkristalls in einer zweiten Phase, in der ein zylindrischer Abschnitt mit einem Zieldurchmesser D_{T} (Stabphase) entsteht, wobei eine Regelung verwendet wird, deren Führungsgröße die Länge des zylindrischen Abschnitts enthält,
und der Wechsel zwischen der ersten Phase und der zweiten Phase dann vollzogen wird, sobald alternativ folgende Kriterien erfüllt sind:
Winkelkriterium: D(t₀) > D_{T} - Δ_{dω} und ω(t₀) < ωₘₐₓ,
Durchmesserkriterium: D(t₀) > D_{T} - Δ_{dd},
wobei die Abweichung vom Zieldurchmesser für das Winkelkriterium Δ_{dω} nicht kleiner ist als 0 mm und nicht größer ist als 6 mm und der maximale Kristallwinkel ωₘₐₓ nicht kleiner ist als 0° und nicht größer ist als 20° und die Abweichung vom Zieldurchmesser für das Durchmesserkriterium Δ_{dd} nicht kleiner ist als -2 mm und nicht größer ist als 5 mm.

Die Merkmale der erfindungsgemäßen Ausführungsformen werden in der Figurenbeschreibung und in den Ansprüchen erläutert. Die einzelnen Merkmale können entweder separat oder in Kombination als Ausführungsformen der Erfindung verwirklicht werden. Weiterhin können sie vorteilhafte Ausführungen beschreiben, die selbstständig schutzfähig sind.

### Kurzbeschreibung der Figuren

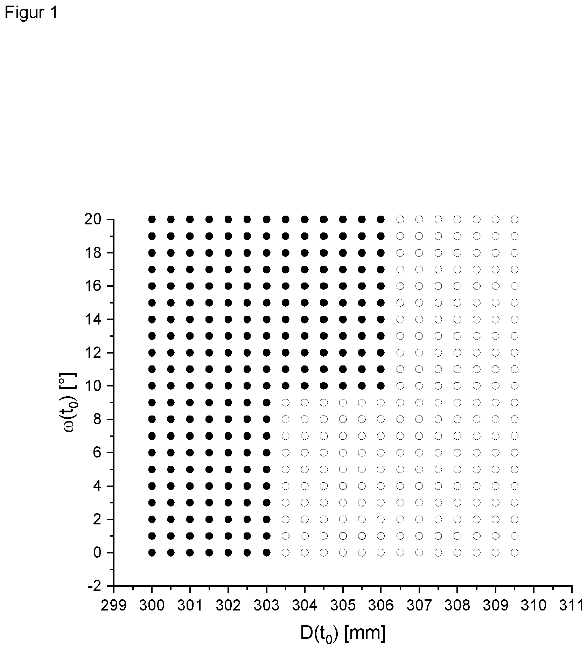

**Figur 1** zeigt exemplarisch das Ergebnis von Entscheidungen bei verschiedenen Eingangssituationen ob sich ein Kristall in der Phase des Anfangskonus oder schon in der Phase der Stabphase befindet. Die ausgefüllten Kreise stehen für die Phase des Anfangskonus und die leeren Kreise für die Stabphase.

Es wurde für dieses Beispiel angenommen, dass der Zieldurchmesser D_{T} 305 mm betragen soll. Ferner wurde ein maximaler Kristallwinkel ωₘₐₓ von 10°, eine Abweichung vom Zieldurchmesser für Durchmesserkriterium Δ_{dd} von -1 mm und eine Abweichung vom Zieldurchmesser für Winkelkriterium Δ_{dω} von 2 mm angenommen. Der Kristall kann sich demnach beispielsweise auch bei einem größeren Ist-Durchmesser als dem Solldurchmesser immer noch in der Phase des Anfangskonus befinden, und zwar dann, wenn der Winkel des Kristalls größer als der angenommene maximaler Kristallwinkel ωₘₐₓ ist.

### Abkürzungen

- t₀:: Zeitpunkt der Messung
- D(t₀):: Ist-Durchmesser zum Zeitpunkt to.
- D_{T}:: Zieldurchmesser
- ω(t₀):: gemessener oder berechneter Winkel des Kristalls gegen die Vertikale zum Zeitpunkt to.
- ωₘₐₓ:: maximaler Kristallwinkel
- Δ_{dd}:: Abweichung vom Zieldurchmesser für Durchmesserkriterium
- Δ_{dω}:: Abweichung vom Zieldurchmesser für Winkelkriterium

### Detaillierte Beschreibung erfindungsgemäßer Ausführungsbeispiele

Die Erfindung sieht den nachstehend beschriebenen Ablauf vor: Halbleitermaterial, vorzugsweise Silizium, wird in einem Tiegel geschmolzen. Die Spitze eines einkristallinen Keimkristalls wird in die Schmelze getaucht und der Keimkristall von der Schmelze weggezogen, wobei am Keimkristall haftendes Material der Schmelze kristallisiert. Zunächst wird ein halsförmiger Abschnitt ("neck") gezogen, um Versetzungen zu beseitigen.

Anschließend wird der Durchmesser D(t) des mit der Zeit t wachsenden Einkristalls erweitert, wodurch ein Anfangskonus entsteht (erste Phase). Während dieser Phase, die bis zum Zeitpunkt t₁ dauert, bei dem die Stabphase (zweite Phase) beginnt, wird der Einkristall vorzugsweise in einer Weise gezogen, die eine Regelung umfasst. Die Regelung ist bevorzugt eine Regelung, deren Führungsgröße den Durchmesser D(t) des Einkristalls enthält.

Bevorzugt ist der Einsatz einer Regelung auf den Kristallwinkel ω, also einer Regelung, bei der als eine Führungsgröße der Kristallwinkel vorgegeben wird, den der Anfangskonus im Bereich der Phasengrenze zur Schmelze mit der Vertikalen einschließen soll. Eine solche Regelung ist beispielsweise in WO 00/60145 A1 beschrieben.

Die Ermittlung des Zeitpunktes t₁, also der Zeitpunkt, ab dem die Stabphase beginnt, enthält erfindungsgemäß das Bestimmen eines Durchmesser D(t₀) und eines Kristallwinkels ω(t₀) zu einem Zeitpunkt t₀.

Erfindungsgemäß wird ferner überprüft, ob folgende Kriterien erfüllt sind:
Winkelkriterium: D(t₀) > D_{T} - Δ_{dω} und ω(t₀) < ωₘₐₓ
Durchmesserkriterium: D(t₀) > D_{T} - Δ_{dd}

Sobald das Winkelkriterium erfüllt ist, ist bevorzugt der Zeitpunkt t₁ des Phasenwechsels zwischen Anfangskonus und Stabphase erreicht.

Erfindungsgemäß ist dabei die Abweichung vom Zieldurchmesser für das Winkelkriterium Δ_{dω} bevorzugt nicht kleiner als 0 mm und nicht größer als 4 mm und besonders bevorzugt nicht kleiner als 2 mm und nicht größer als 4 mm.

Der Wert des maximaler Kristallwinkels ωₘₐₓ ist dabei erfindungsgemäß bevorzugt nicht kleiner als 0° und nicht größer als 20°, besonders bevorzugt nicht größer als 10° und ganz besonders bevorzugt nicht kleiner als 2° und nicht größer als 6°.

Die Erfinder haben bemerkt, dass es in seltenen Fällen vorkommen kann, dass das Winkelkriterium nicht erfüllt wird, obwohl der Durchmesser D(to) schon wesentlich größer ist als der Zieldurchmesser D_{T}. Das zweite erfindungsgemäße Kriterium (Durchmesserkriterium) behebt diesen Mangel.

Die Abweichung vom Zieldurchmesser für das Durchmesserkriterium Δ_{dd} beträgt besonders bevorzugt nicht weniger als -2 mm und nicht mehr als 5 mm.

Die Abweichung vom Zieldurchmesser für das Durchmesserkriterium Δ_{dd} beträgt ganz besonders bevorzugt nicht weniger als -1 mm und nicht mehr als 2 mm.

**Figur 1** zeigt exemplarisch das Ergebnis von Entscheidungen bei verschiedenen Eingangssituationen ob sich ein Kristall in der Phase des Anfangskonus oder schon in der Phase der Stabphase befinden soll. Die ausgefüllten Kreise zeigen, dass der Kristall sich in der Konusphase (Anfangskonus), die leeren Kreise, dass er sich in der Stabphase befindet.

Es wurde für dieses Beispiel angenommen, dass der Zieldurchmesser D_{T} 305 mm betragen soll. Ferner wurde ein maximaler Kristallwinkel ωₘₐₓ von 10°, eine Abweichung vom Zieldurchmesser für Durchmesserkriterium Δ_{dd} von -1 mm und eine Abweichung vom Zieldurchmesser für Winkelkriterium Δ_{dω} von 2 mm angenommen. Der Kristall kann sich demnach beispielsweise auch bei einem größeren Ist-Durchmesser als dem Solldurchmesser immer noch in der Phase des Anfangskonus befinden, und zwar dann, wenn der Winkel des Kristalls kleiner als der angenommene maximaler Kristallwinkel ωₘₐₓ ist.

In folgender Tabelle sind Ergebnisse von Entscheidungen aus Figur 1 noch einmal in Textform wiedergegeben.

**Tabelle 1**

| Beispiel | D(t₀) [mm] | ω(t₀) [°] | D_{T} [mm] | Δ_{dd} [mm] | Δ_{dω} [mm] | ωₘₐₓ [°] | Phase |
|---|---|---|---|---|---|---|---|
| 1 | 302 | 6 | 305 | -1 | 2 | 10 | Anfangskonus |
| 2 | 305 | 6 | 305 | -1 | 2 | 10 | Stabphase |
| 3 | 308 | 6 | 305 | -1 | 2 | 10 | Stabphase |
| 4 | 302 | 14 | 305 | -1 | 2 | 10 | Anfangskonus |
| 5 | 305 | 14 | 305 | -1 | 2 | 10 | Anfangskonus |
| 6 | 308 | 14 | 305 | -1 | 2 | 10 | Stabphase |

Nach dem Erreichen des Zeitpunktes t₁ des Phasenwechsels zwischen Anfangskonus und Stabphase, wird bevorzugt eine Regelung verwendet, deren Führungsgröße die Länge des Kristalls nach dem Erreichen des Zeitpunktes des Phasenwechsels enthält.

## Patentansprüche

1. Verfahren zum Ziehen eines Einkristalls aus Silizium aus einer Schmelze, die in einem Tiegel enthalten ist, umfassend
das Ziehen eines Einkristalls in einer ersten Phase, in der ein Anfangskonus entsteht, wobei ein Durchmesser D(t₀) und ein Kristallwinkel ω(t₀) jeweils zum Zeitpunkt to bestimmt wird und eine Regelung verwendet wird,
deren Führungsgröße den Durchmesser D(t₀) enthält,
und das Ziehen des Einkristalls in einer zweiten Phase, in der ein zylindrischer Abschnitt mit einem Zieldurchmesser D_{T} (Stabphase) entsteht,
wobei eine Regelung verwendet wird, deren Führungsgröße die Länge des zylindrischen Abschnitts enthält,
und der Wechsel zwischen der ersten Phase und der zweiten Phase dann vollzogen wird, sobald alternativ folgende Kriterien erfüllt sind:
Winkelkriterium: D(t₀) > D_{T} - Δ_{dω} und ω(t₀) < ωₘₐₓ,
Durchmesserkriterium: D(t₀) > D_{T} - Δ_{dd},
wobei die Abweichung vom Zieldurchmesser für das Winkelkriterium Δ_{dω} nicht kleiner ist als 0 mm und nicht größer ist als 6 mm
und der maximale Kristallwinkel ωₘₐₓ nicht kleiner ist als 0° und nicht größer ist als 20° und die Abweichung vom Zieldurchmesser für das Durchmesserkriterium Δ_{dd} nicht kleiner ist als -2 mm und nicht größer ist als 5 mm.

2. Verfahren nach Anspruch 1, **dadurch gekennzeichnet, dass** die Abweichung vom Zieldurchmesser für das Winkelkriterium Δ_{dω} nicht kleiner ist als 0 mm und nicht größer ist als 4 mm.

3. Verfahren nach einem der vorstehenden Ansprüche, **dadurch gekennzeichnet, dass** die Abweichung vom Zieldurchmesser für das Winkelkriterium Δ_{dω} nicht kleiner ist als 2 mm und nicht größer ist als 4 mm.

4. Verfahren nach einem der vorstehenden Ansprüche, **dadurch gekennzeichnet, dass** die Abweichung vom Zieldurchmesser für das Durchmesserkriterium Δ_{dd} nicht kleiner ist als -1 mm und nicht größer ist als 2 mm.

5. Verfahren nach einem der vorstehenden Ansprüche, **dadurch gekennzeichnet, dass** der maximale Kristallwinkel ωₘₐₓ nicht kleiner ist als 0° und nicht größer ist als 20°.

6. Verfahren nach einem der vorstehenden Ansprüche, **dadurch gekennzeichnet, dass** und der maximale Kristallwinkel ωₘₐₓ nicht kleiner ist als 2° und nicht größer ist als 10°.

## Geänderte Patentansprüche

### Geänderte Patentansprüche gemäss Regel 137(2) EPÜ.

1. Verfahren zum Ziehen eines Einkristalls aus Silizium aus einer Schmelze, die in einem Tiegel enthalten ist, umfassend
das Ziehen eines Einkristalls in einer ersten Phase, in der ein Anfangskonus entsteht, wobei ein Durchmesser D(to) und ein Kristallwinkel ω(t₀) jeweils zum Zeitpunkt to bestimmt wird, wobei der Kristallwinkel mit der Formel tan⁻¹ (2ΔL/ΔD) berechnet werden kann, wobei ΔD eine zeitliche Änderung des Durchmessers zum Zeitpunkt t₀ und ΔL eine zeitliche Änderung der Länge des Kristallstück zum Zeitpunkt to ist, und eine Regelung verwendet wird,
deren Führungsgröße den Durchmesser D(to) enthält,
und das Ziehen des Einkristalls in einer zweiten Phase, in der ein zylindrischer Abschnitt mit einem Zieldurchmesser D_{T} (Stabphase) entsteht,
wobei eine Regelung verwendet wird, deren Führungsgröße die Länge des zylindrischen Abschnitts enthält,
und der Wechsel zwischen der ersten Phase und der zweiten Phase dann vollzogen wird, sobald alternativ folgende Kriterien erfüllt sind:
Winkelkriterium: D(to) > D_{T} - Δ_{dω} und co(to) < ωₘₐₓ,
Durchmesserkriterium: D(to) > D_{T} - Δ_{dd},
wobei die Abweichung vom Zieldurchmesser für das Winkelkriterium Δ_{dω} nicht kleiner ist als 0 mm und nicht größer ist als 6 mm
und der maximale Kristallwinkel ωₘₐₓ nicht kleiner ist als 0° und nicht größer ist als 20° und die Abweichung vom Zieldurchmesser für das Durchmesserkriterium Δ_{dd} nicht kleiner ist als -2 mm und nicht größer ist als 5 mm.

2. Verfahren nach Anspruch 1, **dadurch gekennzeichnet, dass** die Abweichung vom Zieldurchmesser für das Winkelkriterium Δ_{dω} nicht kleiner ist als 0 mm und nicht größer ist als 4 mm.

3. Verfahren nach einem der vorstehenden Ansprüche, **dadurch gekennzeichnet, dass** die Abweichung vom Zieldurchmesser für das Winkelkriterium Δ_{dω} nicht kleiner ist als 2 mm und nicht größer ist als 4 mm.

4. Verfahren nach einem der vorstehenden Ansprüche, **dadurch gekennzeichnet, dass** die Abweichung vom Zieldurchmesser für das Durchmesserkriterium Δ_{dd} nicht kleiner ist als -1 mm und nicht größer ist als 2 mm.

5. Verfahren nach einem der vorstehenden Ansprüche, **dadurch gekennzeichnet, dass** der maximale Kristallwinkel ωₘₐₓ nicht kleiner ist als 0° und nicht größer ist als 20°.

6. Verfahren nach einem der vorstehenden Ansprüche, **dadurch gekennzeichnet, dass** und der maximale Kristallwinkel ωₘₐₓ nicht kleiner ist als 2° und nicht größer ist als 10°.
